# EUROPÄISCHE PATENTSCHRIFT

(11) **EP 0 671 807 B1**
(45) Veröffentlichungstag und Bekanntmachung des Hinweises auf die Patenterteilung: **10.06.1998**
(21) Anmeldenummer: 95103177.2
(22) Anmeldetag: 06.03.1995
(51) Int. Cl.: H02M 3/335, H03J 9/00

(54) **Schaltnetzteil mit Informationsübertragung von der Primärseite zur Sekundärseite**
Switching power supply with transfer of information from the primary to the secondary side
Alimentation à découpage avec transfert d'information du côté primaire au côté secundaire

(30) Priorität: 07.03.1994 DE 4407529
(43) Veröffentlichungstag der Anmeldung: 13.09.1995
(73) Patentinhaber: SIEMENS AKTIENGESELLSCHAFT, 80333 München (DE)
(72) Erfinder: Feldtkeller, Martin, Dipl.-Ing., D-81543 München (DE); Preller, Peter, Dipl.-Ing., D-81243 München (DE)

(56) Entgegenhaltungen:
- WO-A-93/11609
- DE-A- 3 501 052
- US-A- 4 996 638

## Beschreibung

Die Erfindung betrifft ein Schaltnetzteil nach dem Oberbegriff des Patentanspruchs 1.

Bei Schaltnetzteilen ist es oftmals notwendig, Signale von Einrichtungen, die primärseitig mit Spannung versorgt werden, zu Einrichtungen zu übertragen, die sekundärseitig mit Spannung versorgt werden. Um die erforderliche Potentialtrennung im Signalweg von der Primärseite zur Sekundärseite zu gewährleisten, ist es bisher üblich, einen Optokoppler oder einen entsprechend dimensionierten Transformator zu verwenden. Diese Bauelemente sind nur als diskrete Ausführungsform bekannt. Die schaltungstechnische Realisierung ist demnach aufwendig und teuer.

In der WO 93/11609 ist eine getaktet betriebene Schaltung zur Übertragung eines Ansteuersignals für einen Hochspannungsleistungstransistor über einen Transformator beschrieben. Durch taktweises Anlegen geeignet geschalteter eingangsseitiger Gleichspannungen an die Primärseite des Transformators entstehen sekundärseitig Spannungsimpulse unterschiedlicher Form, die gleichgerichtet werden.

Die Aufgabe der Erfindung besteht darin, ein Schaltnetzteil mit der Möglichkeit einer Signalübertragung von der Primär- auf die Sekundärseite anzugeben, das im Vergleich zu bisherigen Lösungen einfacher realisiert werden kann.

Die Erfindung wird durch ein Schaltnetzteil gemäß den Merkmalen des Patentanspruchs 1 gelöst.

Bei der erfindungsgemäßen Lösung wird das von der Primärauf die Sekundärseite zu übertragende Signal dem Steuersignal, das die Taktsteuerung des Schaltnetzteils bestimmt, aufmoduliert. Die hierzu notwendige primärseitige Modulationseinrichtung und sekundärseitige Demodulationseinrichtung können ohne weiteres als integrierte Schaltungen realisiert werden. Es sind demnach keine weiteren aufwendigen diskreten Bauelemente notwendig.

Die Modulationsart sollte derart beschaffen sein, daß die Spannungsregelung des Schaltnetzteils, die normalerweise durch die Veränderung von Einschalt- und Ausschaltdauer des Primärstroms bewirkt wird, möglichst wenig gestört wird. Für freischwingende Schaltnetzteile ist eine Modulationsart vorteilhaft, bei der eine Impulsflanke des zu übertragenden Signals als ein besonders kurzer, im normalen Betrieb des Schaltnetzteils nicht vorkommender Einschaltimpuls dargestellt wird. In der Demodulationseinrichtung wird dieser kurze Impuls erkannt und in die entsprechende Signalflanke umgewandelt. Bei einem festfrequent betriebenen Schaltnetzteil wird eine Phasen- oder Frequenzmodulation bei Auftreten einer Signalflanke des zu übertragenden Signals durchgeführt. Eine Phasenmodulation kann beispielsweise darin bestehen, daß für eine Taktperiode das Puls-Pausen-Verhältnis des Steuertaktes auf einen Wert geändert wird, der im Normalbetrieb des festfrequenten Schaltnetzteils nicht auftritt.

In einer bevorzugten Ausführungsform wird das zu übertragende Signal von einem Empfänger für Fernbediensignale erzeugt. Nach dem Empfang des Fernbediensignals wird dieses auf die Sekundärseite übertragen und dort in eine Steuerungseinrichtung eingespeist. Die Steuerungseinrichtung, z.B. ein Mikrocontroller, steuert gemäß dem empfangenen Befehl bestimmte Gerätefunktionen. Besonders vorteilhaft kann ein Schaltnetzteil für eine Fernbedienungssteuerung in Zusammenhang mit Stand-by-Betrieb verwendet werden. Durch ein Fernbediensignal zur Einstellung des Stand-by-Betriebs gesteuert wird das Schaltnetzteil abgeschaltet, so daß das versorgte elektrische Gerät sowie der Mikrocontroller stromlos sind. Der Empfänger für die Fernbedienung hingegen wird aus dem Versorgungsnetz mit Spannung gespeist. Da nur der Fernbedienempfänger in Betrieb ist, die übrigen Funktionseinheiten des Schaltnetzteils aber abgeschaltet sind, wird nur sehr wenig Verlustleistung verbraucht. Ein nun eintreffender Fernbedienbefehl für das Umschalten in den Normalbetrieb wird vom Fernbedienempfänger erkannt und sorgt für das Anlaufen des Schaltnetzteils. Das zu versorgende Gerät sowie der Mikrocontroller werden daraufhin mit Spannung versorgt. Es können nun weitere Fernbedienbefehle im Mikrocontroller verarbeitet werden.

Die übliche Taktfrequenz des Schaltnetzteils beträgt 50 kHz. Wenn beispielsweise nach jeweils 100 Impulsen des Steuersignals für den Schalttransistor eine Signalflanke gemäß der Erfindung von der Primär- auf die Sekundärseite übertragen wird, wird eine Bitrate von 500 Bit pro Sekunde für die Signalübertragung erreicht. Erfahrungsgemäß wird bei einer derart niedrigen Bitrate die Spannungsregelung des Schaltnetzteils kaum gestört. Für die Übertragung von Fernbediensignalen, deren Bitrate etwa bei 100 Bit pro Sekunde liegt, ist diese Datenrate ausreichend. Es muß also auch keine zusätzliche Leistungsreserve bei der Dimensionierung des Schaltnetzteils berücksichtigt werden.

Nachfolgend wird die Erfindung anhand der in den Figuren dargestellten Ausführungsbeispielen näher erläutert. Es zeigen
- Figur 1: ein erfindungsgemäßes Schaltnetzteil,
- Figur 2: eine modulierte Impulsfolge,
- Figuren 3a und 3b: eine schaltungstechnische Realisierung des Modulators sowie ein Impulsdiagramm und
- Figuren 4a und 4b: eine schaltungstechnische Realisierung des Demodulators sowie ein Impulsdiagramm.

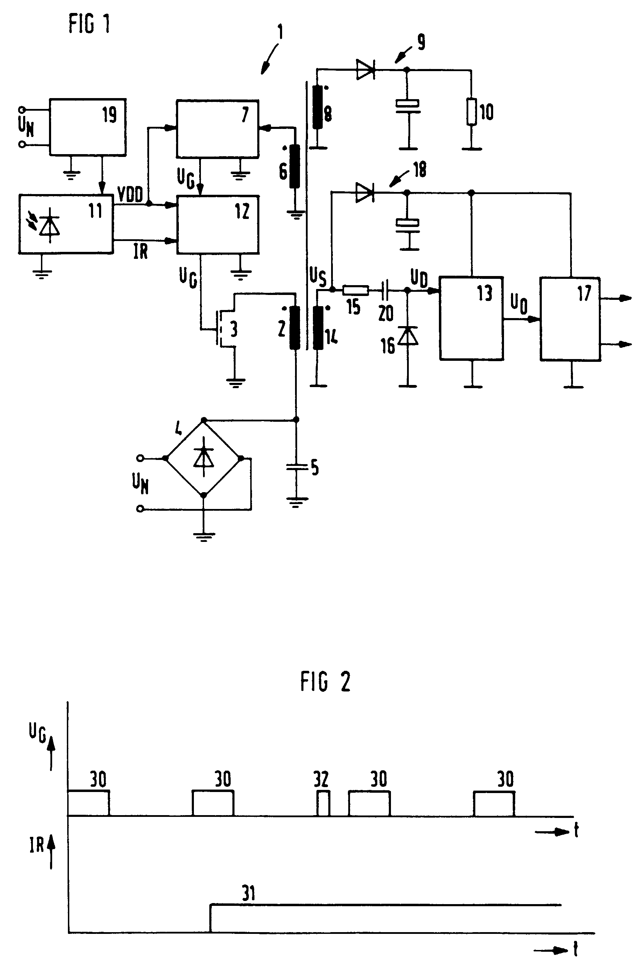

Ein Schaltnetzteil enthält gemäß Figur 1 einen Transformator 1, an dessen Primärwicklung 2 mittels eines Schalttransistors 3 eine aus der Netzwechselspannung U_{N} mittels eines Gleichrichters 4, z.B. eines Brückengleichrichters, gleichgerichtete und über einen Kondensator 5 geglättete Spannung in getakteter Weise angelegt wird. Die Ein- und Ausschaltzeiten des Schalttransistors 3 werden derart geregelt, daß die Sekundärspannung unabhängig von der zu versorgenden Last möglichst konstant ist. Hierzu wird eine der Sekundärspannung proportionale Spannung an einer Regelwicklung 6 abgegriffen und einer Steuerungseinrichtung 7 zugeführt. Die Steuerungseinrichtung 7 ist im wesentlichen als integrierte Schaltung ausgeführt. Als Steuerungseinrichtung 7 kann beispielsweise der integrierte Steuerungsschaltkreis TDA 4605 der Firma Siemens verwendet werden. Über eine Sekundärwicklung 8 und eine aus einer Diode und einem Glättungskondensator bestehende Gleichrichtereinrichtung 9 wird die Last 10 mit Spannung versorgt.

Das Schaltnetzteil weist eine Empfangseinrichtung 11 für ein Fernbediensignal auf. Die Einrichtung 11 kann beispielsweise einen Infrarotempfänger für Fernbediensignale und einen Dekoder enthalten. Der Fernbedienempfänger 11 erzeugt ein Signal IR, das auf die Sekundärseite übertragen werden soll, um dort Gerätefunktionen zu steuern. Hierzu wird das Signal IR in einen Modulator 12 eingespeist, der das von der Steuerungseinrichtung 7 zugeführte Schaltsignal U_{C} entsprechend dem zu übertragenden Signal IR moduliert. Mit dem vom Modulator 12 ausgegebenen, modulierten Steuersignal U_{G} wird der Transistor 3 angesteuert.

Die von der Steuerungseinrichtung 7 erzeugten Steuerimpulse 30 (Figur 2) werden in Abhängigkeit von der von der Regelwicklung 6 gelieferten Regelspannung lastabhängig eingestellt. Zur Übertragung einer Signalflanke 31 des Signals IR auf die Sekundärseite des Schaltnetzteils wird vom Modulator 12 ein kurzer Einschaltimpuls 32 in die Impulsfolge 30 eingefügt. Die Impulsdauer des Impulses 32 ist derart gering, daß die lastabhängige Spannungsregelung nur unwesentlich gestört wird. Ein dem Steuersignal U_{G} für den Schalttransistor 3 in seinen Puls-Pausen-Verhältnissen entsprechendes Signal U_{S} wird an einer weiteren Sekundärwicklung 14 abgegriffen. Die Impulse des Signals U_{G} werden dabei invertiert auf die Sekundärseite übertragen. Über einen strombegrenzenden Längswiderstand 15 und eine Diode 16, deren Katode mit dem Widerstand und deren Anode mit Sekundärmasse verbunden sind, wird die Spannung U_{S} von negativen Anteilen befreit und dem Demodulator 13 zugeführt. Um den Störabstand des Signals U_{D} zu verbessern, ist zwischen Widerstand 15 und Diode 16 ein Koppelkondensator 20 eingefügt, der dafür sorgt, daß der Spannungshub noch weiter ins positive verschoben wird. Im Demodulator 13 wird das ursprünglich übertragene Signal IR demoduliert und einer Steuerungseinrichtung 17, z.B. einem Mikrocontroller, zugeführt. Dieser steuert in Abhängigkeit von dem ihm zugeführten Signal U_{O} Gerätefunktionen des Schaltnetzteils und/oder des mit Spannung versorgten als Last 10 dargestellten elektronischen Geräts. Im vorliegenden Fall wird die Spannungsversorgung des Demodulators 13 und der Steuerungseinrichtung 17 auch von der Sekundärwicklung 14 über eine Gleichrichtereinrichtung 18 gewährleistet.

Eine vorteilhafte Anwendung des erfindungsgemäßen Schaltnetzteils ergibt sich, wie in Figur 1 dargestellt, für die Stand-by-Funktion des Schaltnetzteils. Zur Einstellung des Stand-by-Betriebs werden durch den entsprechenden Befehl im Signal IR die Steuerungseinrichtung 7 sowie der Modulator 12 abgeschaltet. Der Schalttransistor 3 ist dann blokkiert, so daß die Sekundärwicklungen 8, 14 stromlos sind. Während des Stand-by-Betriebs bleibt nur der Fernbedienempfänger 11 aktiv, der hierzu aus dem Versorgungsnetz mit der Spannung U_{N} über eine Stromversorgungseinrichtung 19 mit Spannung versorgt wird. Übliche Fernbedienempfänger, die wie bereits oben angedeutet, im wesentlichen aus einem Infrarotvorverstärker und entsprechenden Dekoder bestehen, verbrauchen relativ wenig Verlustleistung. Deren Stromversorgung 19 kann demnach ohne größeren Bauelementeaufwand auf verlustleistungsarme Weise aus dem Versorgungsnetz abgeleitet werden. Dies kann beispielsweise durch kapazitive Spannungsteilung mit nachgeschalteter Gleichrichtung und Glättung oder durch Gleichrichtung und anschließende ohmsche Spannungsteilung erreicht werden. Gegebenenfalls wird die Stromversorgungseinrichtung 19 am Gleichrichter 4 angeschlossen.

Wenn der Fernbedienempfänger 11 während des Stand-by-Betriebs einen Befehl für das Zurückschalten in den Normalbetrieb erhält, dann wird dieser Befehl im Dekoderteil des Empfänger 11 dekodiert. Daraufhin werden die Steuerungseinrichtung 7 und der Modulator 12 eingeschaltet. Dies erfolgt zweckmäßigerweise dadurch, daß im Empfänger 11 eine Versorgungsspannung VDD für die Einrichtungen 7, 12 erzeugt wird. Durch das Einschalten dieser Spannung VDD wird der Anlauf des Schaltnetzteils gewährleistet.

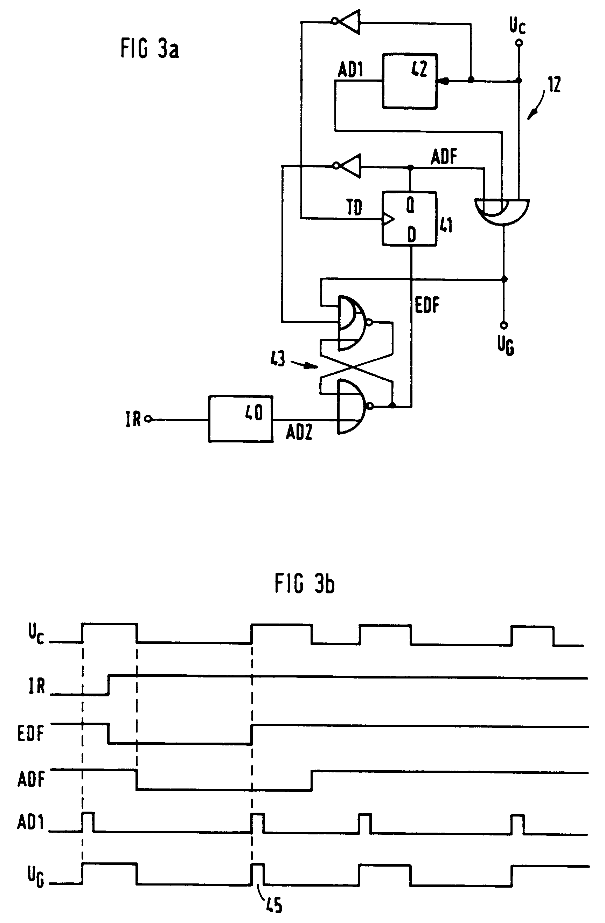

In der Figur 3 ist ein Ausführungsbeispiel für eine Modulatorschaltung 12 gezeigt. Diese enthält als wesentliche Elemente einen Differenzierer 40, der sowohl bei positiven als auch bei negativen Flanken des Fernbediensignals IR einen positiv gerichteten Impuls erzeugt, ein RS-Flip-Flop 43, ein D-Flip-Flop 41 sowie einen Differenzierer 42, der einen positiv gerichteten Impuls bei einer aufsteigenden Flanke erzeugt. Durch diese Schaltung wird erreicht, daß bei einer Flanke des Signals IR ein Impuls 45 erzeugt wird, dessen Länge wesentlich geringer ist als die normalerweise im Schaltbetrieb auftretenden Impulslängen des Signals U_{C}.

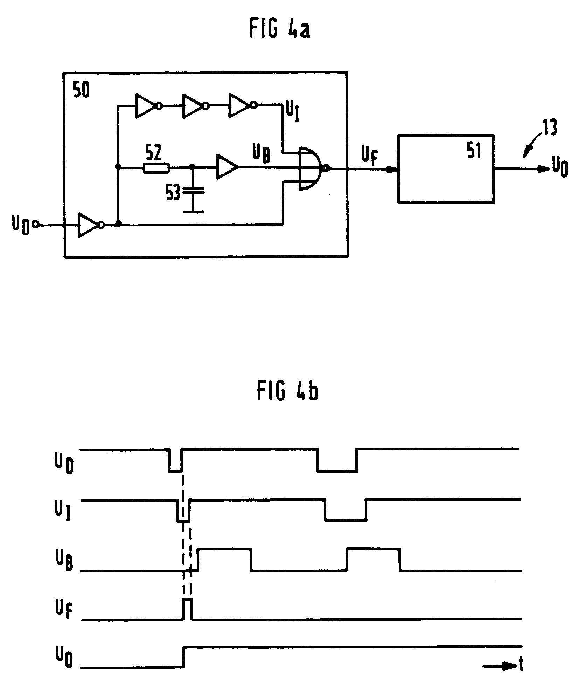

In der Figur 4 ist eine schaltungstechnische Realisierung für die Demodulatorschaltung 13 gezeigt. Diese enthält eine Einrichtung 50, durch die die Impulslänge des Signals U_{D} gemessen wird. Das Signal U_{D} ist bei geschlossenem Schalttransistor 3 durch die Diode 16 auf Masse geklemmt. Bei geöffnetem Schalttransistor 3 ist es positiv. Die auszuwertenden Impulse sind also negativ gerichtet. Die Einrichtung 50 ist in Gatterrealisierung gezeigt, bei der die Impulslängen des Signals U_{D} mit einer über ein RC-Glied 52, 53 eingestellten Verzögerungszeit verglichen werden. Wenn die Impulslänge den durch das RC-Glied festgelegten Wert nicht überschreitet, wird im Signal U_{F} ein Impuls erzeugt. In einer nachfolgenden Speichereinrichtung, vorzugsweise einem Toggle-Flip-Flop wird das zu übertragende Signal IR rekonstruiert. Die Schaltung 50 kann darüber hinaus mittels eines Impulslängenzählers digital ausgeführt werden (nicht dargestellt). Ein solcher Impulslängenzähler enthält beispielsweise einen Zähler, der hochgezählt wird, solange das Signal U_{D} einen negativen Impuls aufweist. Wenn der Impuls eine bestimmte Länge unterschreitet, wird das Ausgangssignal U_{F} der Einrichtung 50 gesetzt.

## Patentansprüche

1. Schaltnetzteil enthaltend
- einen Transformator (1) mit einer Primärwicklung (2) und mit einer Sekundärwicklung (14), die zur Versorgung einer Last (10) mit einer Ausgangsspannung dient, und
- Mittel (7, 3, 4, 5) zum taktweisen Anlegen einer gleichgerichteten Spannung an die Primärwicklung (2) des Transformators (1), die von einem Steuersignal (U_{G}) taktgesteuert werden, wobei die Ausgangsspannung über die Taktsteuerung der Mittel (7, 3, 4, 5) möglichst konstant geregelt wird,
**gekennzeichnet durch**
- eine Modulationseinrichtung (12), durch die das Steuersignal (U_{G}) in Abhängigkeit eines auf die Sekundärseite des Transformators (1) zu übertragenden Signals (IR) moduliert wird, und
- eine Demodulationseinrichtung (13), durch die das zu übertragende Signal (IR) aus einer an der Sekundärwicklung (14) des Transformators (1) anliegenden Spannung (U_{S}) demoduliert wird.

2. Schaltnetzteil nach Anspruch 1,
**gekennzeichnet durch**
eine primärseitig mit Spannung versorgte Einrichtung (11) zum Empfang von Fernbediensignalen, durch die das zu übertragende Signal (IR) erzeugt wird, und eine sekundärseitig mit Spannung versorgte Steuerungseinrichtung (17) zur Steuerung von Funktionsabläufen in Abhängigkeit vom zu übertragenden Signal (IR), der das von der Demodulationseinrichtung (13) demodulierte Signal (U_{O}) zugeführt wird.

3. Schaltnetzteil nach Anspruch 2,
**dadurch gekennzeichnet,**
daß die Einrichtung (11) zum Empfang von Fernbediensignalen aus einer Netzspannung (U_{N}) versorgt wird.

4. Schaltnetzteil nach einem der Ansprüche 1 bis 3,
**dadurch gekennzeichnet,**
daß die Modulationseinrichtung (12) Mittel enthält, durch die die Länge eines Impulses des Steuersignals (U_{G}) verkürzt wird, wenn das zu übertragende Signal (IR) eine Flanke aufweist, und daß die Demodulationseinrichtung (13) Mittel enthält, durch die eine Signalflanke erzeugt wird, wenn ein verkürzter Impuls erkannt wird.

5. Schaltnetzteil nach Anspruch 4,
**dadurch gekennzeichnet,**
daß die Demodulationseinrichtung (13) eine Einrichtung (50) enthält, durch die ein Impuls erzeugt wird, wenn das Eingangssignal (U_{D}) der Demodulationseinrichtung (13) einen Impuls enthält, dessen Länge eine bestimmte Länge unterschreitet, und daß die Demodulationseinrichtung (13) ein von der Einrichtung (50) angesteuertes Speicherelement (51) enthält.

6. Schaltnetzteil nach einem der Ansprüche 1 bis 5,
**dadurch gekennzeichnet,**
daß ein Eingang der Demodulationseinrichtung (13) über einen Widerstand (15) mit einem Anschluß der Sekundärwicklung (14) verbunden ist, daß die Katode einer Diode (16) mit dem Eingang der Demodulationseinrichtung (13) verbunden ist und die Anode mit einem Anschluß für Sekundärmasse, und daß ein anderer Anschluß der Sekundärwicklung (14) mit dem Anschluß für Sekundärmasse verbunden ist.

7. Schaltnetzteil nach Anspruch 6,
**dadurch gekennzeichnet,**
daß zwischen den Widerstand (15) und die Diode (16) ein Koppelkondensator (20) geschaltet ist.

## Claims

1. Switched-mode power supply containing
- a transformer (1) having a primary winding (2) and having a secondary winding (14) which is used to supply a load (10) with an output voltage, and
- means (7, 3, 4, 5) for pulsed application of a rectified voltage to the primary winding (2) of the transformer (1), which means are clock-controlled by a control signal (U_{G}), the output voltage being regulated via the clock control of the means (7, 3, 4, 5) to be as constant as possible,
characterized by
- a modulation device (12) by means of which the control signal (U_{G}) is modulated as a function of a signal (IR) to be transmitted to the secondary of the transformer (1), and
- a demodulation device (13), by means of which the signal (IR) to be transmitted is demodulated from a voltage (U_{S}) which is present on the secondary winding (14) of the transformer (1).

2. Switched-mode power supply according to Claim 1, characterized by a device (11), which is supplied with voltage on the primary side, for reception of remote control signals and by means of which the signal (IR) to be transmitted is produced, and a control device (17), which is supplied with voltage on the secondary side, for controlling function sequences as a function of the signal (IR) to be transmitted, to which control device (17) the signal (U_{O}) which has been demodulated by the demodulation device (13) is supplied.

3. Switched-mode power supply according to Claim 2, characterized in that the device (11) for reception of remote control signals is supplied from a mains voltage (U_{N}).

4. Switched-mode power supply according to one of Claims 1 to 3, characterized in that the modulation device (12) contains means using which the length of a pulse of the control signal (U_{G}) is shortened if the signal (IR) to be transmitted has a flank, and in that the demodulation device (13) contains means using which a signal flank is produced if a shortened pulse is identified.

5. Switched-mode power supply according to Claim 4, characterized in that the demodulation device (13) contains a device (50) using which a pulse is produced if the input signal (U_{D}) of the demodulation device (13) contains a pulse whose length is less than a specific length, and in that the demodulation device (13) contains a storage element (51) which is driven by the device (50).

6. Switched-mode power supply according to one of Claims 1 to 5, characterized in that one input of the demodulation device (13) is connected via a resistor (15) to one connection of the secondary winding (14), in that the cathode of a diode (16) is connected to the input of the demodulation device (13) and the anode is connected to a connection for secondary earth, and in that another connection of the secondary winding (14) is connected to the connection for the secondary earth.

7. Switched-mode power supply according to Claim 6, characterized in that a coupling capacitor (20) is connected between the resistor (15) and the diode (16).

## Revendications

1. Alimentation à découpage comportant
- un transformateur (1), ayant un enroulement primaire (2) et un enroulement secondaire (14), qui sert à alimenter une charge (10) d'une tension de sortie, et
- des moyens (7, 3, 4, 5) pour l'application commandée par horloge d'une tension redressée à l'enroulement primaire (2) du transformateur (1), ces moyens étant commandés par horloge par un signal de commande (U_{G}), la tension de sortie étant réglée la plus constante possible par l'intermédiaire de la commande par horloge des moyens (7, 3, 4, 5),
caractérisée par
- un dispositif de modulation (12) qui module le signal de commande (U_{G}) en fonction d'un signal (IR) à transmettre au côté secondaire du transformateur (1), et
- un dispositif de démodulation (13) qui démodule le signal à transmettre (IR) à partir d'une tension (U_{S}) présente à l'enroulement secondaire (14) du transformateur (1).

2. Alimentation à découpage selon la revendication 1,
caractérisée par un dispositif (11), alimenté en tension du côté primaire, destiné à la réception de signaux de télécommande et produisant le signal à transmettre (IR), et par un dispositif de commande (17), alimenté en tension du côté secondaire, destiné à la commande d'exécutions de fonctions selon le signal à transmettre (IR) et recevant le signal (U_{O}) démodulé par le dispositif de démodulation (13).

3. Alimentation à découpage selon la revendication 2,
caractérisée par le fait que le dispositif (11) destiné à la réception de signaux de télécommande est alimenté à partir d'une tension de réseau (U_{N}).

4. Alimentation à découpage selon l'une des revendications 1 à 3,
caractérisée par le fait que le dispositif de modulation (12) comporte des moyens qui réduisent la longueur d'une impulsion du signal de commande (U_{G}) lorsque le signal à transmettre (IR) présente un front, et le dispositif de démodulation (13) comporte des moyens qui produisent un front de signal lorsqu'une impulsion réduite est détectée.

5. Alimentation à découpage selon la revendication 4,
caractérisée par le fait que le dispositif de démodulation (13) comporte un dispositif (50) qui produit une impulsion lorsque le signal d'entrée (U_{D}) du dispositif de démodulation (13) présente une impulsion dont la longueur est inférieure à une certaine longueur, et le dispositif de démodulation (13) comporte un élément de mémorisation (51) commandé par le dispositif (50).

6. Alimentation à découpage selon l'une des revendications 1 à 5,
caractérisée par le fait qu'une entrée du dispositif de démodulation (13) est reliée par l'intermédiaire d'une résistance (15) à une borne de l'enroulement secondaire (14), que la cathode d'une diode (16) est reliée à l'entrée du dispositif de démodulation (13) et l'anode est reliée à une borne de masse secondaire, et qu'une autre borne de l'enroulement secondaire (14) est reliée à la borne de masse secondaire.

7. Alimentation à découpage selon la revendication 6,
caractérisée par le fait qu'un condensateur de couplage (20) est branché entre la résistance (15) et la diode (16).
